(19) Europäisches Patentamt
European Patent Office
Office européen des brevets

(11) **EP 2 802 532 B1**

(12) **FASCICULE DE BREVET EUROPEEN**

(45) Date de publication et mention
de la délivrance du brevet:
**06.11.2019 Bulletin 2019/45**

(21) Numéro de dépôt: **13705580.2**

(22) Date de dépôt: **11.01.2013**

(51) Int Cl.:
*C01B 33/037* (2006.01)   *C30B 11/00* (2006.01)
*C30B 29/06* (2006.01)

(86) Numéro de dépôt international:
**PCT/IB2013/050275**

(87) Numéro de publication internationale:
**WO 2013/105060 (18.07.2013 Gazette 2013/29)**

(54) **PROCÉDÉ DE PURIFICATION DU SILICIUM**

VERFAHREN ZUR REINIGUNG VON SILICIUM

METHOD FOR PURIFYING SILICON

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.01.2012 FR 1250364**

(43) Date de publication de la demande:
**19.11.2014 Bulletin 2014/47**

(73) Titulaire: **Commissariat à l'Énergie Atomique et aux Énergies Alternatives 75015 Paris (FR)**

(72) Inventeurs:
• **GARANDET, Jean-Paul**
  **F-73370 Le Bourget Du Lac (FR)**
• **ALBARIC, Mickaël**
  **F-73290 La Motte Servolex (FR)**
• **AUDOIN, Claire**
  **F-38330 Saint Ismier (FR)**
• **CHAVRIER, Denis**
  **F-73000 Chambery (FR)**
• **PIHAN, Etienne**
  **F-73290 La Motte Servolex (FR)**

(74) Mandataire: **Nony**
  **11 rue Saint-Georges**
  **75009 Paris (FR)**

(56) Documents cités:
**WO-A1-2010/069784   WO-A1-2011/033188 FR-A5- 2 058 114**

• **LIAO Y H ET AL: "STUDY OF THE TRANSPORT PHENOMENA OF SOLAR GRADE SILICON PREPARED BY THE BRIDGMAN-STOCKBARGER PROCESS.", SOLAR ENERGY MATERIALS 1987 JUL, vol. 15, no. 5, juillet 1987 (1987-07), pages 351-365, XP002682922,**
• **GALGALI R K ET AL: "STUDIES ON SLAG REFINING AND DIRECTIONAL SOLIDIFICATION IN THE PURIFICATION OF SILICON", SOLAR ENERGY MATERIALS, NORTH-HOLLAND PUBLISHING COMPANY, AMSTERDAM, NL, vol. 16, no. 4, 1 octobre 1987 (1987-10-01), pages 297-307, XP001301158, ISSN: 0165-1633**

EP 2 802 532 B1

**Description**

La présente invention concerne les procédés de purification du silicium.

Les cellules photovoltaïques sont majoritairement fabriquées à partir de silicium mono- ou poly-cristallin dans des filières qui mettent en jeu la solidification de lingots à partir d'un bain liquide contenu dans un creuset.

La charge, utilisée comme matériau de base, est classiquement élaborée par un procédé de distillation d'un précurseur chloré obtenu à partir d'un silicium de grade métallurgique. Ce procédé est très efficace pour la purification, mais coûteux en termes d'investissement financier et de consommation énergétique.

Depuis quelques années, des procédés alternatifs ont été proposés pour la fabrication d'un silicium de qualité solaire à partir de procédés relevant de la métallurgie.

On connait, en effet, des procédés de solidification directionnelle permettant une ségrégation des impuretés, et, par conséquent, une purification des charges de départ.

Pour la purification du silicium, la technique peut être bien adaptée aux impuretés métalliques (Fe, Cr, Ni...) dont les coefficients de partage sont très petits devant l'unité.

Il est rappelé que le coefficient de partage k mesure le rapport entre les concentrations d'une impureté entre la phase solide et la phase liquide à l'interface de solidification.

Un faible coefficient de partage permet, par conséquent, d'envisager une purification par ségrégation très efficace.

On sait, par ailleurs, qu'une vitesse de solidification élevée va dans le sens d'une mauvaise ségrégation.

Cependant, il est parallèlement souhaitable de privilégier une vitesse de solidification élevée, typiquement supérieure à 5 $\mu$m/s, dans un souci de réduction des coûts des procédés de purification du silicium.

Ainsi, il est connu d'utiliser des systèmes de brassage extrinsèques dans des procédés mettant en œuvre des vitesses de solidification élevées. Toutefois, compte tenu des tailles des bains liquides utilisés au niveau industriel et des niveaux de convection nécessités par de telles vitesses de solidification, l'écoulement peut être instationnaire, voire turbulent.

De ce fait, des variations également instationnaires pour la vitesse de croissance et pour l'incorporation des impuretés peuvent être obtenues. De telles conditions peuvent se traduire, au niveau de la globalité du lingot, par une dégradation de la capacité à ségréger les impuretés.

Cela peut se comprendre d'un point de vue qualitatif, car dans des conditions instationnaires, la majeure partie des lingots est solidifiée aux moments du cycle où la vitesse de solidification est supérieure à la moyenne et donc où l'incorporation des impuretés est maximale. Un tel enseignement est discuté dans la publication F.Z. Haddad, J.P. Garandet, D. Henry, H. Ben Hadid, J. Crystal Growth 204 (1999) 213. WO2011/033188 A1 concerne un procédé de fusion / purification / solidification d'une charge de silicium métallurgique, procédé dans lequel un brassage de la charge fondue est assuré par exemple par brassage électromagnétique.

Il existe, par conséquent, un besoin pour disposer d'un procédé de purification du silicium assurant une bonne ségrégation dans des conditions de vitesse de solidification élevée.

La présente invention vise à répondre au besoin précité.

Selon un premier aspect, la présente invention concerne un procédé de purification du silicium comportant au moins les étapes consistant à :

a) disposer d'un récipient comportant du silicium à l'état fondu, le récipient présentant un axe longitudinal et le silicium à l'état fondu définissant du côté opposé au fond du récipient une surface libre,

b) imposer au silicium à l'état fondu des conditions propices à sa solidification, la vitesse moyenne temporelle sur la durée de l'étape b) de propagation du front de solidification du silicium, mesurée le long de l'axe longitudinal du récipient, étant supérieure ou égale à 5 $\mu$m/s, de préférence à 10 $\mu$m/s,

ledit procédé étant caractérisé en ce qu'au moins un système de brassage impose, durant tout ou partie de l'étape b), un écoulement de silicium à l'état fondu de nombre de Reynolds compris entre $3 \cdot 10^4$ et $3 \cdot 10^6$, de préférence entre $10^5$ et $10^6$.

L'axe longitudinal du récipient désigne la ligne joignant l'ensemble des barycentres des sections transversales dudit récipient (parois du récipient incluses). L'axe longitudinal peut être un axe de symétrie pour le récipient. L'axe longitudinal du récipient est de préférence rectiligne, et peut être contenu dans un plan, lequel peut être un plan de symétrie pour certaines, voire toutes les sections transversales dudit récipient.

Le nombre de Reynolds Re de l'écoulement de silicium à l'état fondu imposé par le système de brassage

$$\mathrm{Re} = \frac{V \times L}{\nu}.$$

est donné par la relation :

Dans cette formule :

- V désigne la vitesse instantanée maximale des particules de fluide de silicium à l'état fondu mises en mouvement par le système de brassage,
- L désigne la plus petite dimension transversale du récipient, et
- $\nu$ désigne la viscosité cinématique du silicium à l'état fondu, par exemple $3{,}5 \cdot 10^{-7}$ m²/s tel qu'indiqué dans la publication de Sasaki et al. Jpn J. Appl. Phys., 34 :3432 (1995).

Ainsi, dans l'exemple où le système de brassage est, comme il sera détaillé plus loin, une hélice rotative, V correspond à la vitesse instantanée des extrémités distales de l'hélice.

Les inventeurs ont constaté qu'imposer, durant tout ou partie de l'étape b), au silicium à l'état fondu un écoulement de nombre de Reynolds particulier permettait avantageusement d'obtenir une ségrégation efficace, conduisant ainsi à l'obtention de silicium à l'état solide particulièrement pur et ce malgré les vitesses de solidifications élevées mises en œuvre.

Sans vouloir être lié à une théorie particulière, les inventeurs considèrent que les valeurs de nombre de Reynolds sélectionnées dans le cadre des procédés selon l'invention permettent avantageusement d'obtenir une couche limite hydrodynamique visqueuse d'épaisseur supérieure à la couche limite solutale.

Ainsi, vis-à-vis de la ségrégation des impuretés, l'écoulement peut donc être considéré comme visqueux, évitant ainsi les problèmes d'incorporation transitoire des impuretés évoqués dans l'état de l'art.

Par ailleurs, du fait de son action sur le champ de température, le système de brassage peut avantageusement permettre d'augmenter localement les gradients thermiques au voisinage du front de solidification, tout en les réduisant dans le cœur du bain liquide. Cette réduction du gradient thermique dans le cœur permet de réduire la température maximale du bain, diminuant ainsi la solubilisation des impuretés présentes au sein des parois du récipient et/ou du revêtement optionnellement présent au niveau desdites parois comme il sera détaillé ci-après.

Préalablement à l'étape a), du silicium à l'état solide peut être introduit dans le récipient et y être ensuite fondu. En variante, le procédé comporte une étape d'introduction dans le récipient de silicium à l'état fondu.

Le silicium à l'état fondu peut être au contact ou non des parois du récipient. Ainsi, dans un exemple de réalisation, les parois du récipient peuvent être revêtues d'un revêtement anti-adhérent.

Le système de brassage peut avantageusement être présent au sein du silicium à l'état fondu durant tout ou partie de l'étape b), l'écoulement forcé de silicium à l'état fondu étant, dans ce cas, généré du fait de la mise en mouvement dudit système de brassage.

Dans ce cas, le déplacement du système de brassage, de préférence, comporte, notamment consiste en, un mouvement de rotation.

Le mouvement de rotation peut être réalisé autour d'un axe de rotation faisant, avec au moins une portion de l'axe longitudinal du récipient, un angle inférieur à 45 °, notamment à 30 °, notamment à 15 °, l'axe de rotation étant notamment colinéaire à l'axe longitudinal du récipient.

De préférence, le système de brassage présent au sein du silicium à l'état fondu durant tout ou partie de l'étape b), effectue, durant tout ou partie de l'étape b), un mouvement de rotation à une vitesse comprise entre 5 et 200 tours/minute, de manière préférée entre 10 et 100 tours/minute.

Le système de brassage permet, par exemple, d'obtenir, durant tout ou partie de l'étape b), une vitesse instantanée maximale des particules de fluide de silicium à l'état fondu comprise entre 1 et 100 cm/s, notamment 5 et 50 cm/s.

Le sens de rotation du système de brassage peut être modifié durant l'étape b).

Le système de brassage peut être introduit dans le silicium à l'état fondu avant le début de la solidification du silicium.

Le système de brassage peut être introduit dans le silicium à l'état fondu et y être mis en rotation avant le début de la solidification du silicium.

Le système de brassage est, de préférence, un système de brassage mécanique.

Le système de brassage comporte, par exemple, une hélice, une pale et/ou un disque.

Le système de brassage comporte, de manière particulièrement préférée, une hélice ou une pale, lesquelles peuvent, durant tout ou partie de l'étape b), être présentes au sein du silicium à l'état fondu et être animées d'un mouvement de rotation.

Le système de brassage peut être déplacé relativement au récipient, notamment selon son axe longitudinal, durant l'étape b).

L'écoulement du silicium à l'état fondu peut être généré par l'action de plusieurs systèmes de brassage.

Le brassage peut être interrompu avant solidification complète du silicium.

Le système de brassage peut être retiré du silicium à l'état fondu avant solidification complète du silicium.

En variante, le système de brassage n'est présent, à aucun moment durant l'étape b), au sein du silicium à l'état fondu. Le système de brassage peut, dans ce cas, comporter un générateur de champ électromagnétique, alternatif, glissant ou tournant, l'écoulement de silicium à l'état fondu étant, durant l'étape b), généré par application dudit champ électromagnétique. Des exemples de la formation d'un écoulement forcé par la génération d'un champ électromagnétique sont décrits dans l'article de Mitric et al, J. Crystal Growth, 310 (2008), 1424 pour le champ alternatif, dans l'article de Rudolph, 2008, J. Crystal Growth, 310, 1298 pour le champ glissant, et dans l'article de Dold et al, J. Crystal Growth, 231 (2001), 95 pour le champ tournant.

Le procédé peut comporter une étape c) de refroidissement, notamment jusqu'à température ambiante, du silicium à l'état solide obtenu à l'issue de l'étape b).

L'expression « température ambiante » désigne la température de 20°C ± 5°C.

Le procédé peut comporter une étape d) de récupération du silicium à l'état solide purifié obtenu à l'issue de l'étape c).

L'étape d) comporte avantageusement une étape d'élimination de la matière enrichie en composés autres que le silicium.

Cette étape d'élimination peut être réalisée par découpes des parties latérales, inférieure et supérieure du lingot obtenu.

Indépendamment ou en combinaison avec ce qui précède, l'invention concerne, selon un autre de ses aspects, un procédé de purification du silicium comportant au moins les étapes consistant à :

a) disposer d'un récipient comportant du silicium à l'état fondu, le récipient présentant un axe longitudinal et le silicium à l'état fondu définissant du côté opposé au fond du récipient une surface libre,
b) imposer au silicium à l'état fondu des conditions propices à sa solidification, la vitesse moyenne temporelle sur la durée de l'étape b) de propagation du front de solidification du silicium, mesurée le long de l'axe longitudinal du récipient, étant supérieure ou égale à 5 $\mu$m/s, de préférence à 10 $\mu$m/s,

ledit procédé étant caractérisé en ce qu'au moins un système de brassage impose, durant tout ou partie de l'étape b), un écoulement de silicium à l'état fondu permettant d'obtenir, durant tout ou partie de l'étape b), un rapport des coefficients de partage effectif et thermodynamique

$$\frac{k_{eff}}{k}$$

des composés autres que le silicium inférieur à 2, de préférence à 1,25.

Le coefficient de partage effectif $k_{eff}$ d'une espèce donnée est relié au coefficient de partage thermodynamique k de cette même espèce par la relation suivante :

$$k_{eff} = \frac{k}{1-(1-k)\dfrac{\delta V_I}{D}}.$$

Dans la relation ci-dessus :

- $\delta$ désigne l'épaisseur de la couche limite solutale à l'avant du front de solidification obtenue en présence de l'écoulement de silicium à l'état fondu imposé par le système de brassage,
- $V_I$ désigne la vitesse de propagation du front de solidification du silicium mesurée selon l'axe longitudinal du récipient, et
- D désigne le coefficient de diffusion de l'espèce considérée.

Indépendamment ou en combinaison avec ce qui précède, l'invention concerne, selon encore un autre de ses aspects, un procédé de purification du silicium comportant au moins les étapes consistant à :

a) disposer d'un récipient comportant du silicium à l'état fondu, le récipient présentant un axe longitudinal et le silicium à l'état fondu définissant du côté opposé au fond du récipient une surface libre,
b) imposer au silicium à l'état fondu des conditions propices à sa solidification, la vitesse moyenne temporelle sur la durée de l'étape b) de propagation du front de solidification du silicium, mesurée le long de l'axe longitudinal du récipient, étant supérieure ou égale à 5 $\mu$m/s, de préférence à 10 $\mu$m/s,

ledit procédé étant caractérisé en ce qu'au moins un système de brassage impose, durant tout ou partie de l'étape b), un écoulement de silicium à l'état fondu permettant d'obtenir, durant tout ou partie de l'étape b), un rapport

$$\frac{\delta V_I}{D}$$

pour les composés autres que le silicium inférieur à 0,5, de préférence à 0,2, les grandeurs $\delta$, $V_I$ et D étant telles que définies ci-dessus.

Les procédés définis ci-dessus peuvent avantageusement permettre d'obtenir du silicium à l'état solide purifié présentant une concentration massique en silicium supérieure ou égale à 99,99 %, de préférence à 99,999 %.

**Protocole de mesure de la vitesse de propagation du front de solidification du silicium**

La vitesse de propagation du front de solidification du silicium, mesurée le long de l'axe longitudinal du récipient, est évaluée par palpage mécanique de la phase solide au travers de la phase liquide au moyen d'une canne en céramique réfractaire. Plus précisément, l'opérateur introduit la canne, par exemple de silice, dans le bain fondu au cours de la solidification et vient contacter l'interface solide/liquide, pour mesurer la position de l'interface. Cette opération est réalisée plusieurs fois au cours de la solidification et permet de calculer une vitesse temporelle moyenne de l'interface. Cette méthode de mesure est connue de l'homme du métier et couramment utilisée dans le milieu industriel du fait de sa robustesse et de sa simplicité.

**Détermination des coefficients de partage**

Coefficient de partage k

Pour une impureté donnée, le coefficient de partage k est tabulé dans le référence F.A. Trumbore, Bell Syst. Tech. J., vol 39, p205, 1960.

Coefficient de partage effectif $k_{eff}$

Le coefficient de partage effectif est mesuré *via* un ajustement des profils de concentration mesurés par exemple par spectroscopie d'absorption atomique (« AAS : Atomic Absorption Sprectroscopy ») ou spectrométrie de masse à plasma couplé par induction (« ICP-MS : Inductively Coupled Plasma - Mass Spectroscopy ») réalisé a *posteriori* sur les lingots solidifiés.

**Descriptions des figures**

L'invention pourra être mieux comprise à la lecture de la description détaillée qui va suivre, d'exemples de mise en œuvre non limitatifs de celle-ci, et à l'examen du dessin annexé, sur lequel :

- la figure 1 illustre, de manière schématique et partielle, une section d'un récipient utilisable dans le cadre de la présente invention, et
- la figure 2 illustre, de manière schématique et partielle, l'étape de solidification du silicium mise en œuvre dans le cadre des procédés selon l'invention.
- La figure 3 représente un graphique de la concentration en aluminium en fonction de la hauteur de silicium solidifiée obtenue dans le cadre de l'invention et dans un essai témoin sans brassage.

Dans les dessins annexés, les proportions réelles des différents éléments n'ont pas nécessairement été respectées, dans un souci de clarté.

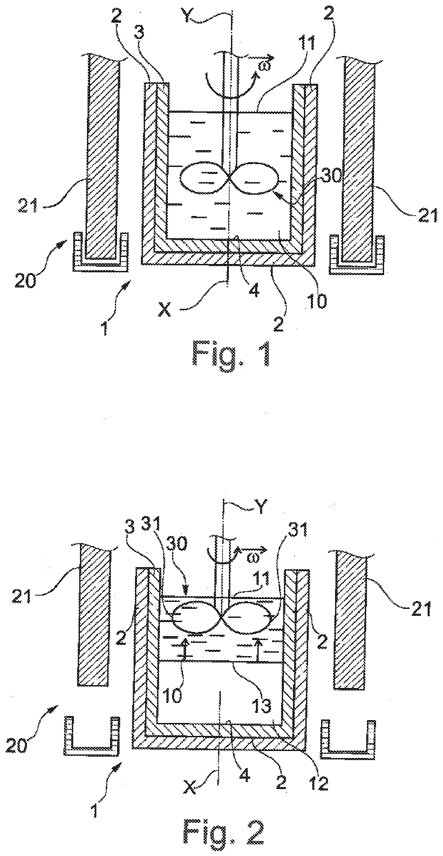

On a illustré à la figure 1 un récipient 1 d'axe longitudinal X dont les parois internes 2 ont été revêtues par un revêtement 3 anti-adhérent. Le récipient 1 présente un fond 4.

Le récipient 1 utilisé peut, par exemple, être un creuset en silice et le revêtement 3 anti-adhérent peut être constitué par une couche de nitrure de silicium.

Le récipient 1 comporte, comme illustré, du silicium 10 à l'état fondu définissant une surface libre 11 du côté opposé au fond 4 du récipient 1. Le silicium 10 à l'état fondu peut être obtenu par fusion de silicium solide initialement présent dans le récipient 1. En variante, le silicium peut être fondu sous vide au-dessus du récipient 1 et le remplissage du récipient 1 peut être réalisé en injection ou dépression.

Des moyens de chauffage (non représentés) permettent le maintien du silicium 10 à l'état fondu en soumettant ce dernier à une température supérieure à sa température de fusion.

Un système de brassage sous la forme d'une hélice 30 est positionné au sein du silicium 10 à l'état fondu et est, comme illustré, animé d'un mouvement de rotation autour de l'axe de rotation Y lequel est colinéaire à l'axe longitudinal X. On ne sort pas du cadre de la présente invention si l'axe Y forme un angle non nul avec l'axe X.

L'hélice 30 peut, comme illustré, avant le début de la solidification du silicium être introduite sensiblement à mi hauteur du récipient 1.

Concernant le problème d'évacuation de la chaleur, un système d'isolation thermique 20 comportant notamment des volets 21 isolants en position fermée est, par exemple, présent afin de réduire les échanges thermiques avant le début de la solidification du silicium.

On a illustré à la figure 2 l'état du système à un instant donné durant l'étape b). Comme illustré, les volets isolants 21 sont en position ouverte permettant ainsi les échanges thermiques et, par conséquent, la solidification du silicium.

Le front de solidification 13 du silicium, séparant silicium 10 à l'état fondu et silicium 12 à l'état solide, se propage à une vitesse moyenne, mesurée le long de l'axe longitudinal X du récipient 1, supérieure ou égale à 5 $\mu$m/s, de préférence à 10 $\mu$m/s.

Comme illustré, le front de solidification 13 progresse depuis le fond 4 du récipient 1 vers la surface libre 11 durant l'étape b).

Il va des compétences de l'homme du métier de régler les caractéristiques des transferts thermiques afin d'obtenir les valeurs souhaitées de vitesse de propagation du front de solidification du silicium.

Comme illustré à la figure 2, l'hélice 30 a été déplacée relativement au récipient 1 selon l'axe longitudinal X de ce dernier, ce déplacement ayant eu lieu durant la solidification du silicium, et impose une vitesse maximale aux particules de fluide situées au voisinage de ses extrémités distales 31.

**Exemples**

Exemple 1

Une charge de silicium d'environ 60 kg, sous forme de cailloux de dimensions centimétriques, est introduite dans un creuset silice de marque Vesuvius et de dimensions intérieures 39x39x39 cm, sur lequel un revêtement anti-adhérent de nitrure de silicium avait été préalablement déposé. Le silicium utilisé peut être de grade métallurgique, comprenant notamment 150 ppm massique d'Al.

L'ensemble est ensuite introduit dans le dispositif de solidification, un four vertical de technologie à refroidissement contrôlé sans déplacement mécanique (« gradient freeze », en terminologie anglo-saxonne), avec des éléments chauffants (résistors graphite) situés en partie haute et sur les côtés du creuset. Le silicium est d'abord porté à une température de 1430°C pour assurer sa fusion complète.

Le brasseur mécanique (pale de silice référencée DA 00194, de fabrication Vesuvius, et de longueur 7,5cm) est ensuite introduit dans le bain fondu, positionné à mi-hauteur dans le bain, et mis en rotation à une vitesse angulaire de 15 tours/minute. Le nombre de Reynolds obtenu est ici de 1,3.10^5.

Pour initier la solidification, l'extraction de chaleur en partie basse est ensuite augmentée par le biais de l'ouverture contrôlée de volets isolants.

Quand environ la moitié du silicium a été solidifié, le brasseur est remonté et positionné 2 cm au dessous de l'interface entre le liquide et l'atmosphère de l'enceinte, tout en maintenant la rotation à une vitesse angulaire de 15 tours/minute.

Quand l'interface solide-liquide s'approche à moins de 4 cm de l'interface liquide-vapeur, le brasseur est remonté hors du bain et la rotation est stoppée. La solidification complète du lingot de 25 cm de hauteur est réalisée en 7 heures environ, la vitesse moyenne de solidification est donc 3,6 cm/h, ou de façon équivalente 10 $\mu$m/s. En régime de croissance, la puissance consommée par le four est d'environ 38 kW.

La puissance de chauffe est ensuite réduite et le lingot ramené à température ambiante et démoulé du creuset.

Le profil de concentration en Al dans le lingot solidifié est ensuite mesuré par spectrométrie de masse à plasma couplé par induction (ICP-MS : « Inductively Coupled Plasma - Mass Spectroscopy » en terminologie anglaise). L'ajustement (« fit ») par une loi de Scheil en fonction de la fraction solidifiée donne une valeur de 2,4 $10^{-3}$. Rapporté à la valeur de référence pour le coefficient de partage thermodynamique (k = 2 $10^{-3}$), le rapport $k_{eff}$ / k est de 1,2.

La loi de Scheil est classiquement utilisée comme référence par l'homme de l'art pour rendre compte des profils de ségrégation chimique dans les procédés de solidification dirigée. D'un point de vue mathématique, les hypothèses sous-jacentes sont de supposer que le liquide peut-être à chaque instant considéré comme homogène en concentration, et que la diffusion dans le solide peut être négligée. Dans ces conditions, la loi de Scheil représente un minimum en matière de quantité d'impuretés incorporées en fonction de la fraction solidifiée et donc un optimum en termes de purification.

Exemple 2

Une charge de silicium d'environ 60 kg, sous forme de cailloux de dimensions centimétriques, est introduite dans un creuset silice de marque Vesuvius et de dimensions intérieures 39x39x39 cm, sur lequel un revêtement anti-adhérent de nitrure de silicium avait été préalablement déposé. Le silicium utilisé est de grade métallurgique, comprenant notamment 2000 ppm massique de Fe.

L'ensemble est ensuite introduit dans le dispositif de solidification, un four vertical de technologie à refroidissement contrôlé sans déplacement mécanique (« gradient freeze »), avec des éléments chauffants (résistors graphite) situés en partie haute et sur les côtés du creuset.

Le silicium est d'abord porté à une température de 1430°C pour assurer sa fusion complète. Le brasseur mécanique (pale de silice référencée DA 00194, de fabrication Vesuvius) est ensuite introduit dans le bain fondu, positionné à mi-hauteur dans le bain, et mis en rotation à une vitesse angulaire de 70 tours/minute (soit un nombre de Reynolds de 6.$10^5$).

Pour initier la solidification, l'extraction de chaleur en partie basse est ensuite augmentée par le biais de l'ouverture contrôlée de volets isolants. En régime de croissance, la puissance consommée par le four est d'environ 38 kW. Quand environ la moitié du silicium a été solidifié, le brasseur est remonté et positionné 2 cm au dessous de l'interface entre le liquide et l'atmosphère de l'enceinte, tout en maintenant la rotation à une vitesse angulaire de 70 tours/minute.

Quand l'interface solide-liquide s'approche à moins de 4 cm de l'interface liquide-vapeur, le brasseur est remonté hors du bain et la rotation est stoppée.

La solidification complète du lingot de 25 cm de hauteur est réalisée en 7 h environ, la vitesse moyenne de solidification est donc 3,6 cm/h, ou de façon équivalente 10 $\mu$m/s. La puissance de chauffe est ensuite réduite et le lingot ramené à température ambiante et démoulé du creuset.

Le profil de concentration en Fe dans le lingot solidifié est ensuite mesuré par spectrométrie de masse à plasma couplé par induction (ICP-MS : Inductively Coupled Plasma - Mass Spectroscopy en terminologie anglaise). L'ajustement (« fit ») par une loi de Scheil en fonction de la fraction solidifiée donne une valeur de 1,1 $10^{-5}$. Rapporté à la valeur de référence pour le coefficient de partage thermodynamique (k = $10^{-5}$), le rapport $k_{eff}$ / k est de 1,1.

Exemple 3

Caractérisation de l'effet bénéfique du brassage selon l'invention sur la purification par solidification unidirectionnelle du silicium.

A des fins comparatives, il a été réalisé conjointement à une purification conforme à l'invention, une purification sans application d'un brassage.

La charge de silicium de départ est dans les 2 cas contaminé par 500 ppm massique d'Al.

Les conditions expérimentales retenues en termes de creuset utilisé, de grade, quantité et forme du silicium de départ, de dispositif de solidification et de température de chauffage sont similaires à celles retenues pour les exemples 1 et 2.

Pour ce qui concerne la purification conforme à l'invention, le système de brassage utilisé est de type mécanique comprenant une pâle identique à celui des exemples 1 et 2. Celui-ci est introduit dans le bain fondu, positionné à mi-hauteur dans le bain, et mis en rotation à une vitesse angulaire de 50 tours/minute (soit un nombre de Reynolds de 2,1.$10^5$). Pour initier la solidification, l'extraction de chaleur en partie basse du four est ensuite augmentée par le biais de l'ouverture contrôlée de volets isolants. En régime de croissance, la puissance consommée par le four est d'environ 38 kW. Quand environ la moitié du silicium a été solidifié, le brasseur est remonté et positionné 2 cm au-dessous de l'interface entre le liquide et l'atmosphère de l'enceinte, tout en maintenant la rotation à une vitesse angulaire de 50 tours/minute. Quand l'interface solide-liquide s'approche à moins de 4 cm de l'interface liquide-vapeur, le brasseur est remonté hors du bain et la rotation est stoppée.

Les conditions de procédé (hormis bien évidemment tout ce qui concerne le système de pale) sont identiques pour l'expérience de solidification sans brassage.

Pour les deux types d'expériences réalisées (conforme à l'invention ou sans système de brassage), la solidification complète du lingot de 25 cm de hauteur est réalisée en 7 h environ, la vitesse moyenne de solidification est donc 3, 6 cm/h, ou de façon équivalente 10 $\mu$m/s, comme dans les exemples 1 et 2. La puissance de chauffe est ensuite réduite et le lingot ramené à température ambiante et démoulé du creuset.

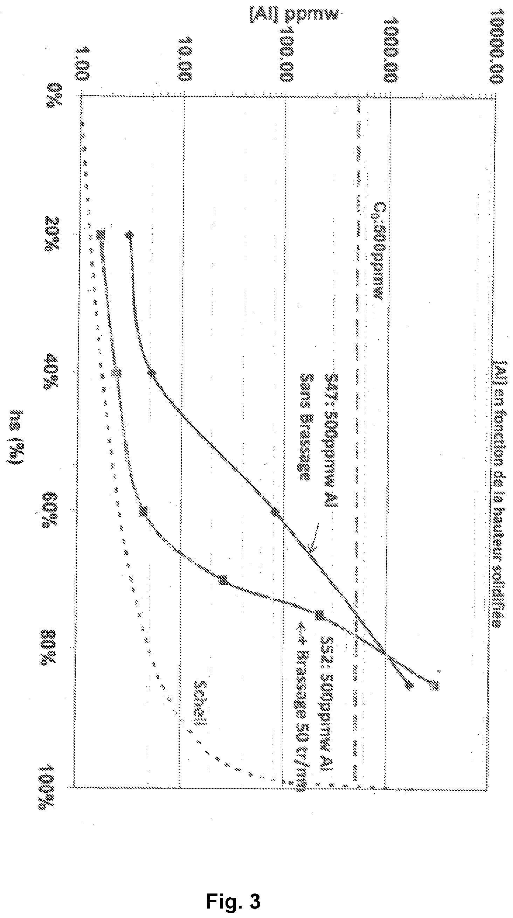

En figure 3 sont présentées les courbes représentatives de la concentration en aluminium en fonction de la hauteur de silicium solidifiée.

A titre de témoin, y figure également la courbe modélisant la solidification du silicium selon la loi de Scheil.

Lorsqu'il n'y a pas de système de brassage, il apparaît que la courbe représentant l'évolution de la concentration en aluminium en fonction de la hauteur de solidification est éloignée de la courbe représentative de la loi de ségrégation de Scheil.

En revanche, le graphique de la figure 3 met en évidence qu'un brassage mécanique comprenant une pâle, maintenu à une vitesse de rotation angulaire de 50 tours/minute de telle sorte à atteindre un nombre de Reynolds de 2,1 10$^5$, permet de se rapprocher nettement de la loi de ségrégation de Scheil.

Sauf mention contraire, l'expression « comportant/comprenant un(e) » doit être comprise comme « comportant/comprenant au moins un(e) ».

Sauf mention contraire, l'expression « compris(e) entre ... et ... » doit s'entendre comme bornes incluses.

Sauf mention contraire, l'expression «allant de ... à ... » doit s'entendre comme bornes incluses.

## Revendications

**1.** Procédé de purification du silicium comportant au moins les étapes consistant à :

a) disposer d'un récipient (1) comportant du silicium (10) à l'état fondu, le récipient (1) présentant un axe (X) longitudinal et le silicium (10) à l'état fondu définissant du côté opposé au fond (4) du récipient (1) une surface libre (11),
b) imposer au silicium (10) à l'état fondu des conditions propices à sa solidification, la vitesse moyenne temporelle sur la durée de l'étape b) de propagation du front (13) de solidification du silicium, mesurée le long de l'axe (X) longitudinal du récipient (1), étant supérieure ou égale à 5 $\mu$m/s, de préférence à 10 $\mu$m/s,

ledit procédé étant **caractérisé en ce qu'**au moins un système de brassage (30) impose, durant tout ou partie de l'étape b), un écoulement de silicium (10) à l'état fondu de nombre de Reynolds compris entre 3 10$^4$ et 3 10$^6$, de préférence entre 10$^5$ et 10$^6$.

**2.** Procédé selon la revendication 1, **caractérisé en ce que** le système de brassage (30) est présent au sein du silicium (10) à l'état fondu, durant tout ou partie de l'étape b), et **en ce que** l'écoulement de silicium (10) à l'état fondu est généré du fait de la mise en mouvement dudit système de brassage (30).

**3.** Procédé selon la revendication précédente, **caractérisé en ce que** le déplacement du système de brassage (30) comporte, notamment consiste en, un mouvement de rotation, ledit mouvement de rotation étant de préférence réalisé autour d'un axe (Y) de rotation faisant, avec au moins une portion de l'axe (X) longitudinal, un angle inférieur à 45 °, notamment à 30 °, notamment à 15 °, l'axe (Y) de rotation étant notamment colinéaire à l'axe (X) longitudinal du récipient (1).

**4.** Procédé selon la revendication 3, **caractérisé en ce que** le sens de rotation du système de brassage (30) est modifié durant l'étape b).

**5.** Procédé selon l'une quelconque des revendications 2 à 4, **caractérisé en ce que** le système de brassage (30) est un système de brassage mécanique, comportant notamment une hélice, une pale et/ou un disque, ledit système de brassage (30) comportant, de préférence, une hélice.

**6.** Procédé selon l'une quelconque des revendications précédentes, **caractérisé en ce que** le système de brassage (30) est déplacé relativement au récipient (1), notamment selon son axe (X) longitudinal, durant l'étape b).

**7.** Procédé selon l'une quelconque des revendications précédentes, **caractérisé en ce que** le front (13) de solidification progresse depuis le fond (4) du récipient (1) vers la surface libre (11) durant l'étape b).

**8.** Procédé selon l'une quelconque des revendications précédentes, **caractérisé en ce que** les parois (2) internes du récipient (1) sont revêtues d'un revêtement (3) anti adhérent.

**9.** Procédé selon l'une quelconque des revendications précédentes, **caractérisé en ce que** le brassage est interrompu avant solidification complète du silicium.

**10.** Procédé selon l'une quelconque des revendications précédentes, **caractérisé en ce que** l'écoulement du silicium (10) à l'état fondu est généré par l'action de plusieurs systèmes de brassage.

**11.** Procédé selon l'une quelconque des revendications précédentes, **caractérisé en ce que**, préalablement à l'étape a), du silicium à l'état solide est introduit dans le récipient et y est ensuite fondu.

**12.** Procédé selon l'une quelconque des revendications précédentes, **caractérisé en ce que** le rapport des coefficients de partage effectif et thermodynamique

$$\frac{k_{eff}}{k}$$

des composés autres que le silicium est, durant tout ou partie de l'étape b), inférieur à 2, de préférence à 1,25.

**13.** Procédé selon l'une quelconque des revendications précédentes, **caractérisé en ce qu'**il comporte une étape c) de refroidissement, notamment jusqu'à température ambiante, du silicium (12) à l'état solide obtenu à l'issue de l'étape b), ledit procédé comportant de préférence en outre une étape d) de récupération du silicium (12) à l'état solide purifié obtenu à l'issue de l'étape c).

**14.** Procédé selon la revendication 13, **caractérisé en ce que** l'étape d) comporte une étape d'élimination de la matière enrichie en composés autres que le silicium.

**Patentansprüche**

**1.** Verfahren zur Reinigung von Silicium, umfassend mindestens die Schritte, die darin bestehen:

a) einen Behälter (1) bereitzustellen, der Silicium (10) in geschmolzenem Zustand enthält, wobei der Behälter (1) eine Längsachse (X) aufweist und das Silicium (10) in geschmolzenem Zustand auf der dem Boden (4) des Behälters (1) entgegengesetzten Seite eine freie Fläche (11) definiert,
b) dem Silicium (10) in geschmolzenem Zustand Bedingungen aufzuprägen, die günstig für seine Erstarrung sind, wobei die mittlere zeitliche Geschwindigkeit der Ausbreitung der Erstarrungsfront (13) des Siliciums über die Dauer des Schritts b), gemessen entlang der Längsachse (X) des Behälters (1), größer als oder gleich 5 $\mu$m/s, bevorzugt größer als oder gleich 10 $\mu$m/s ist,

wobei das Verfahren **dadurch gekennzeichnet ist,**

**dass** mindestens ein Rührsystem (30) während des gesamten oder eines Teils des Schritts b) eine Strömung von Silicium (10) in geschmolzenem Zustand mit einer Reynolds-Zahl zwischen $3 \cdot 10^4$ und $3 \cdot 10^6$, bevorzugt zwischen $10^5$ und $10^6$ aufprägt.

**2.** Verfahren nach Anspruch 1, **dadurch gekennzeichnet, dass** das Rührsystem (30) in dem Silicium (10) in geschmolzenem Zustand während des gesamten oder eines Teils des Schritts b) vorhanden ist und dass die Strömung des Siliciums (10) in geschmolzenem Zustand durch das Inbewegungversetzen des Rührsystems (30) erzeugt wird.

**3.** Verfahren nach dem vorhergehenden Anspruch, **dadurch gekennzeichnet, dass** die Verlagerung des Rührsystems (30) eine Drehbewegung umfasst, insbesondere in einer solchen besteht, wobei die Drehbewegung bevorzugt um eine Drehachse (Y) ausgeführt wird, die mit mindestens einem Abschnitt der Längsachse (X) einen Winkel von weniger als 45°, insbesondere als 30°, insbesondere als 15° bildet, wobei die Drehachse (Y) insbesondere kollinear zur Längsachse (X) des Behälters (1) ist.

**4.** Verfahren nach Anspruch 3, **dadurch gekennzeichnet, dass** die Drehrichtung des Rührsystems (30) während des Schritts b) geändert wird.

**5.** Verfahren nach einem der Ansprüche 2 bis 4, **dadurch gekennzeichnet, dass** das Rührsystem (30) ein mechanisches Rührsystem ist, das insbesondere einen Propeller, ein Blatt und/oder eine Scheibe aufweist, wobei das Rührsystem (30) bevorzugt einen Propeller aufweist.

**6.** Verfahren nach einem der vorhergehenden Ansprüche, **dadurch gekennzeichnet, dass** das Rührsystem (30) während des Schritts b) relativ zum Behälter (1) verlagert wird, insbesondere entlang seiner Längsachse (X).

**7.** Verfahren nach einem der vorhergehenden Ansprüche, **dadurch gekennzeichnet, dass** die Erstarrungsfront (13) während des Schritts b) vom Boden (4) des Behälters (1) aus zur freien Fläche (11) hin fortschreitet.

**8.** Verfahren nach einem der vorhergehenden Ansprüche, **dadurch gekennzeichnet, dass** die Innenwände (2) des Behälters (1) mit einer Antihaftbeschichtung (3) beschichtet sind.

**9.** Verfahren nach einem der vorhergehenden Ansprüche, **dadurch gekennzeichnet, dass** das Rühren vor dem vollständigen Erstarren des Siliciums abgebrochen wird.

**10.** Verfahren nach einem der vorhergehenden Ansprüche, **dadurch gekennzeichnet, dass** die Strömung des Siliciums (10) in geschmolzenem Zustand durch die Einwirkung mehrerer Rührsysteme erzeugt wird.

**11.** Verfahren nach einem der vorhergehenden Ansprüche, **dadurch gekennzeichnet, dass** vor dem Schritt a) Silicium im festen Zustand in den Behälter eingebracht und anschließend darin geschmolzen wird.

**12.** Verfahren nach einem der vorhergehenden Ansprüche, **dadurch gekennzeichnet, dass** der Quotient aus den effektiven und thermodynamischen Verteilungskoeffizienten $\frac{k_{eff}}{k}$ der Verbindungen außer dem Silicium während des gesamten oder eines Teils des Schritts b) kleiner als 2, bevorzugt kleiner als 1,25 ist.

**13.** Verfahren nach einem der vorhergehenden Ansprüche, **dadurch gekennzeichnet, dass** es einen Schritt c) des Abkühlens, insbesondere bis auf Raumtemperatur, des am Ende des Schritts b) erhaltenen Siliciums (12) in festem Zustand umfasst, wobei das Verfahren bevorzugt ferner einen Schritt d) der Rückgewinnung des am Ende des Schritts c) erhaltenen gereinigten Siliciums (12) in festem Zustand umfasst.

**14.** Verfahren nach Anspruch 13, **dadurch gekennzeichnet, dass** der Schritt d) einen Schritt der Eliminierung des an Verbindungen außer Silicium angereicherten Materials umfasst.

**Claims**

**1.** A process for purifying silicon comprising at least steps consisting in:

a) providing a container (1) containing molten silicon (10), the container (1) having a longitudinal axis (X) and the molten silicon (10) defining on the side opposite the bottom (4) of the container (1) a free surface (11);
b) imposing on the molten silicon (10) conditions that promote its solidification, the propagation speed of the solidification front (13) of the silicon, time averaged over the duration of step b) and measured along the longitudinal axis (X) of the container (1), being higher than or equal to 5 $\mu$m/s and preferably 10 $\mu$m/s,

said process being **characterized in that** at least one stirring system (30) imposes, throughout all or part of step b), a flow of molten silicon (10) of Reynolds number comprised between $3 \times 10^4$ and $3 \times 10^6$ and preferably between $1 \times 10^5$ and $1 \times 10^6$.

**2.** The process as claimed in claim 1, **characterized in that** the stirring system (30) is present in the molten silicon (10) throughout all or part of step b), and **in that** the flow of molten silicon (10) is generated by making said stirring system (30) move.

**3.** The process as claimed in the preceding claim, **characterized in that** the movement of the stirring system (30) comprises and especially consists of a rotary movement, said rotary movement preferably occurring about an axis (Y) of rotation making, with at least one portion of the longitudinal axis (X), an angle smaller than 45°, especially than 30° and particularly than 15°, the axis (Y) of rotation especially being colinear with the longitudinal axis (X) of the container (1).

**4.** The process as claimed in claim 3, **characterized in that** the direction of rotation of the stirring system (30) is modified in step b).

**5.** The process as claimed in any one of claims 2 to 4, **characterized in that** the stirring system (30) is a mechanical stirring system especially comprising a propeller, a vane and/or a disc, said stirring system (30) preferably comprising a propeller.

**6.** The process as claimed in any one of the preceding claims, **characterized in that** the stirring system (30) is moved relative to the container (1), especially along its longitudinal axis (X), in step b).

**7.** The process as claimed in any one of the preceding claims, **characterized in that** the solidification front (13) progresses from the bottom (4) of the container (1) toward the free surface (11) in step b).

**8.** The process as claimed in any one of the preceding claims, **characterized in that** the internal walls (2) of the container (1) are coated with a nonstick coating (3).

**9.** The process as claimed in any one of the preceding claims, **characterized in that** the stirring is stopped before the silicon has completely solidified.

**10.** The process as claimed in any one of the preceding claims, **characterized in that** the flow of molten silicon (10) is generated by the action of a plurality of stirring systems.

**11.** The process as claimed in any one of the preceding claims, **characterized in that**, before step a), solid silicon is introduced into the container and then melted therein.

12. The process as claimed in any one of the preceding claims, **characterized in that** the ratio $\dfrac{k_{eff}}{k}$ of the effective and equilibrium segregation coefficients of compounds other than silicon is, throughout all or part of step b), lower than 2 and preferably than 1.25.

13. The process as claimed in any one of the preceding claims, **characterized in that** it comprises a step c) of cooling, especially down to room temperature, the solid silicon (12) obtained at the end of step b), said process preferably comprising a step d) of recovering the purified solid silicon (12) obtained at the end of step c).

14. The process as claimed in claim 13, **characterized in that** step d) comprises a step of removing material enriched with compounds other than silicon.

Fig. 1

Fig. 2

**Fig. 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2011033188 A1

**Littérature non-brevet citée dans la description**

- **F.Z. HADDAD ; J.P. GARANDET ; D. HENRY ; H. BEN HADID.** *J. Crystal Growth,* 1999, vol. 204, 213
- **SASAKI et al.** *Jpn J. Appl. Phys.,* 1995, vol. 34, 3432
- **MITRIC et al.** *J. Crystal Growth,* 2008, vol. 310, 1424
- **RUDOLPH.** *J. Crystal Growth,* 2008, vol. 310, 1298
- **DOLD et al.** *J. Crystal Growth,* 2001, vol. 231, 95
- **F.A. TRUMBORE.** *Bell Syst. Tech. J.,* 1960, vol. 39, 205